# EUROPÄISCHE PATENTSCHRIFT

(11) **EP 0 534 273 B1**
(45) Veröffentlichungstag und Bekanntmachung des Hinweises auf die Patenterteilung: **15.05.1996**
(21) Anmeldenummer: 92115715.2
(22) Anmeldetag: 14.09.1992
(51) Int. Cl.: G03F 7/09, G03F 7/095, G03F 7/038

(54) **Verfahren zur Erzeugung eines Bottom-Resists**
Method for producing a bottom-resist
Procédé pour préparer une couche de fond à partir d'une photoréserve

(30) Priorität: 27.09.1991 DE 4132313
(43) Veröffentlichungstag der Anmeldung: 31.03.1993
(73) Patentinhaber: SIEMENS AKTIENGESELLSCHAFT, D-80333 München (DE)
(72) Erfinder: Leuschner, Rainer, Dr., W-8520 Erlangen (DE); Sezi, Recai, Dr., W-8551 Röttenbach (DE); Sebald, Michael, Dr., W-8521 Hessdorf-Hahnberg (DE)

(56) Entgegenhaltungen:
- DE-A- 3 707 844
- IBM TECHNICAL DISCLOSURE BULLETIN Bd. 31, Nr. 6, November 1988, ARMONK, NY, USA Seite 11 , XP97311 'Epoxy Novolak Underlayers for High Optical Transparency and Thermal Stability'
- IBM TECHNICAL DISCLOSURE BULLETIN Bd. 15, Nr. 7, Dezember 1972, ARMONK, NY, USA Seiten 2339 - 2340 L.H. KAPLAN UND S. ZIRINSKY 'Two and Three-Layer Photoresist Technique'

## Beschreibung

Die Erfindung betrifft ein Verfahren zur Erzeugung eines Bottom-Resists für ein Zweilagen-O₂/RIE-System.

Bei der photolithographischen Erzeugung von Resiststrukturen mit Licht einer Wellenlänge von ca. 250 nm sind - bei hoher Wafertopographie - Zweilagen-O₂/RIE-Systeme (RIE = Reactive Ion Etching) eine der wenigen Möglichkeiten, um auch bei kleiner Tiefenschärfe der abbildenden Optik noch maßhaltige Strukturen erzeugen zu können. Dabei wird auf einen planarisierenden und absorbierenden Bottom-Resist ein siliciumhaltiger oder silylierbarer Top-Resist aufgebracht. Dieser Top-Resist wird dann belichtet und entwickelt sowie gegebenenfalls silyliert oder chemisch aufgeweitet, und anschließend wird die dabei erhaltene Struktur mittels eines Sauerstoffplasmas in den Bottom-Resist übertragen (siehe beispielsweise: "Microelectr. Eng.", Vol. 11 (1990), Seiten 531 bis 534).

Der Bottom-Resist muß folgende Eigenschaften besitzen:
- hohe Ätzresistenz gegen Substratätzung
- Wärmeformbeständigkeit über 100 °C
- Unlöslichkeit in Lösungsmitteln für den Top-Resist, Entwicklerlösungen und gegebenenfalls Silylierungs- bzw. Aufweitungslösungen
- hohe Absorption bei der Belichtungswellenlänge
- gute Planarisierungseigenschaften
- leichte Entfernbarkeit mittels ungefährlicher Strippmedien.

Die letztgenannte Forderung ist insbesondere dann von Bedeutung, wenn das Zweilagen-O₂/RIE-System für sogenannte Lift-off-Prozesse verwendet werden soll (siehe dazu: W. Scot Ruska, Microelectronic Processing", McGraw-Hill Book Company, 1987, Seiten 227 bis 230).

Als Bottom-Resist werden im allgemeinen gewöhnliche Novolak-Resists verwendet, die bei Temperaturen über 200 °C ausgeheizt werden und auf diese Weise in Lösungsmitteln und Entwicklerlösungen unlöslich werden (siehe dazu: "Proc. SPIE", Vol. 1262 (1990), Seiten 528 bis 537). Vielfach werden als Bottom-Resist auch bei ca. 400 °C getemperte Polyimid-Vorstufen eingesetzt, die bei dieser Temperatur in unlösliche Polyimide umgewandelt werden (siehe: "J. Electrochem. Soc.", Vol. 135 (1988), Seiten 2896 bis 2899, sowie "Solid State Technology", Juni 1987, Seiten 83 bis 89). Derartige Resistsysteme weisen einen hohen Aromatenanteil auf und sind - aufgrund des Ausheizprozesses - sogar noch ätzstabiler als gewöhnliche Photoresists auf Novolakbasis, bei denen der Ausheizprozeß zur Vernetzung führt. Allerdings sind diese Resistsysteme so unlöslich, daß sie durch übliche Strippmedien nicht mehr entfernt werden können.

Ausgeheizte Novolake können nur durch oxidierende starke Säuren entfernt werden, wie Caro'sche Säure, d.h. Peroxomonoschwefelsäure (H₂SO₅), oder rauchende Salpetersäure. Jedoch vertragen nicht alle Substrate eine derartige Behandlung. So ist beispielsweise Aluminium, das als Material für Leiterbahnen verwendet wird, in Caro'scher Säure löslich und kann durch oxidierende Medien leicht in Aluminiumoxid übergeführt werden. Ein Strippen des Bottom-Resists mit derartigen Medien würde deshalb zu einer Schädigung der Leiterbahnen führen. Bei der Verwendung von rauchender Salpetersäure würde das Aluminium zwar passiviert werden, dieses Strippmedium ist jedoch in toxikologischer Hinsicht bedenklich. Polyimide andererseits lassen sich durch hydrazinhaltige Lösungen, wie Gemische aus Ethylendiamin und Hydrazinhydrat, entfernen, aber auch gegen derartige Lösungen bestehen erhebliche toxikologische Bedenken, da der MAK-Wert von Hydrazin bei nur 5 ppm liegt.

Häufig werden Resists auch mittels eines Sauerstoffplasmas entfernt, wobei sie zu CO, CO₂ und H₂O oxidiert werden. Sind im Falle von Zweilagensystemen nach der Substratätzung jedoch noch Reste des siliciumhaltigen Top-Resists vorhanden, so würde das Silicium zu SiO₂ oxidiert werden, das dann in Form feiner Partikel auf dem Wafer verbleibt und zu Defekten führen kann.

Zur Erzielung einer guten Planarisierung sind für Bottom-Resists auch bereits Materialien bekannt, die nicht thermisch, sondern photolytisch gehärtet werden (siehe dazu: "Polym. Mater. Sci. Eng.", Vol. 60 (1989), Seiten 385 bis 389). Hierbei handelt es sich um aromatische Methacryl- und Epoxyverbindungen. Diese Materialien weisen aber eine um wenigstens 20 % geringere Ätzstabilität auf als Novolake. Um dieses Manko auszugleichen, sind dickere Schichten erforderlich. Die bekannten Systeme erfordern ferner lediglich eine reine UV-Härtung. Eine Härtung kann deshalb bereits beim Plasmaätzen durch das dabei auftretende UV-Licht erfolgen.

Es ist ferner bekannt, bei Zweilagen-O₂/RIE-Systemen für die Lift-off-Technik eine zusätzliche Abhebeschicht aus Polysulfon zu verwenden, über der noch eine Novolakschicht aufgebracht wird (siehe: "J. Electrochem. Soc.", Vol. 138 (1991), Seiten 1765 bis 1769). Nach dem Ausheizen des Novolaks bleibt das Polysulfon noch löslich (in N-Methylpyrrolidon), so daß die unter Verwendung eines siliciumhaltigen Resists strukturierte Schicht mittels eines Lift-off-Prozesses entfernt werden kann. Eine derartige Vorgehensweise erfordert zwei zusätzliche Schichten (aus verschiedenen Materialien). Je mehr zusätzliche Belackungsschritte aber erforderlich sind, desto mehr erhöht sich in der Regel die Defektdichte.

Aufgabe der Erfindung ist es, ein Verfahren anzugeben, das die Erzeugung eines Bottom-Resists für ein Zweilagen-O₂/RIE-System erlaubt, der alle an einen derartigen Resist gestellten Anforderungen erfüllt, wobei insbesondere eine leichte Entfernbarkeit gegeben sein muß.

Dies wird erfindungsgemäß dadurch erreicht, daß auf ein Substrat eine Lackschicht aus einem aromatenhaltigen Basispolymer, einem Vernetzer und einem Säurebildner aufgebracht wird, daß die Lackschicht - zur Freisetzung einer starken Säure aus dem Säurebildner im Oberflächenbereich der Schicht - flutbelichtet wird, und daß thermisch gehärtet wird.

Beim erfindungsgemäßen Verfahren wird ein aromatenhaltiges Basispolymer eingesetzt, d.h. ein Polymer, das gegen Halogen-Substratätzprozesse ausreichend stabil ist und somit eine Ätzstabilität aufweist, die mindestens derjenigen von Novolaken entspricht. Bevorzugt wird als Basispolymer deshalb auch ein Novolak verwendet. Daneben können beispielsweise auch Polybenzoxazol-Vorstufen eingesetzt werden.

Das Basispolymer wird in Lösung - zusammen mit einem Vernetzer und einer latenten Säure - auf ein Substrat aufgebracht, das im allgemeinen ein Wafer ist. Nach dem Aufbringen, das insbesondere durch Spin-coating geschieht, erfolgt eine Vortrocknung. Als Vernetzer dient vorzugsweise Hexamethylentetramin oder eine Novolak-Vorstufe. Daneben können beispielsweise auch Benzylether (siehe dazu: "Proc. SPE", Ellenville N.Y. (1988), Seiten 63 bis 72) sowie Melaminharz-Vorstufen (siehe dazu: "Proc. SPE", Ellenville N.Y. (1985), Seiten 49 bis 64) eingesetzt werden. Die latente Säure, d.h. der Säurebildner, ist vorzugsweise eine Verbindung, die bei Belichtung Chlorwasserstoff abspaltet. Ferner kommen für diesen Zweck sogenannte Crivello-Salze in Frage, d.h. Oniumverbindungen, wie Sulfonium- und Jodoniumverbindungen.

Das Basispolymer wird mit dem Vernetzer - unter Säurekatalyse - thermisch gehärtet; die Härtung erfolgt im allgemeinen bei Temperaturen > 100 °C. Die dazu erforderliche Säure wird auf photolytischem Weg erzeugt, aber nur im Oberflächenbereich der Lackschicht. Auf diese Weise wird erreicht, daß der Bottom-Resist nur an der Oberfläche vernetzt wird und damit stabil gegen das Lösungsmittel für den Top-Resist und gegen den Entwickler sowie gegebenenfalls gegen eine Silylierungs- bzw. Aufweitungslösung ist. Nach der Strukturerzeugung im Top-Resist und deren Ubertragung in den Bottom-Resist mittels Sauerstoffplasma werden auch tiefere, unvernetzte Schichtbereiche freigelegt, so daß der Bottom-Resist - zusammen mit auf der Oberfläche verbliebenen Resten des Top-Resists - mit einem untoxischen organischen Lösungsmittel abgelöst werden kann. Dies erfolgt beispielsweise mittels N-Methylpyrrolidon in einer Art Lift-off-Prozeß.

Bei der Strukturübertragung im Sauerstoffplasma entsteht UV-Licht und das Substrat erwärmt sich auf ca. 100 °C. Dies ist in besonderem Maße bei Magnetronätzanlagen der Fall, die als Einzelscheibenätzanlagen von besonderer Bedeutung sind. Dieses UV-Licht bzw. die Erwärmung kann bei gängigen Bottom-Resists ausreichen, um eine - an sich unerwünschte - Vernetzung zu bewirken. Wird beispielsweise eine im Handel erhältliche photovernetzbare Polyimid-Vorstufe eingesetzt, so läßt sich diese photolytisch härten. Wird dieses Material nach dem Ätzen im Sauerstoffplasma mit einem organischen Lösungsmittel behandelt, d.h. gestrippt, so werden zwar Linien abgelöst, die sich in einem engen Gitter befinden, da sie sich gegenseitig ausreichend abschatten. Isoliert stehende Resistlinien bleiben jedoch stehen, da hierbei die Resistflanken durch das im Plasma erzeugte UV-Licht vernetzt wurden und somit für das Strippmedium unlöslich geworden sind.

Beim erfindungsgemäßen Verfahren wird zwar die Säure photolytisch erzeugt, eine Härtungsreaktion erfolgt hierbei aber nur dann, wenn das Substrat - gleichzeitig oder nachfolgend - auf eine Temperatur > 100 C erwärmt wird, vorzugsweise auf eine Temperatur von ca. 140 bis 150 °C. Da diese Temperaturen im Plasma nicht erreicht werden, besteht bei diesem Verfahren nicht die Gefahr, daß isolierte Linien nicht abgelöst werden und somit Defekte entstehen. Außerdem können hierbei unbedenkliche, d.h. wenig gesundheitsgefährdende organische Lösungsmittel verwendet werden, um den Resist vollständig zu entfernen.

Beim erfindungsgemäßen Verfahren ist es wesentlich, daß die Härtung des Bottom-Resists auf den Oberflächenbereich der Lackschicht beschränkt wird. Um dies sicherzustellen, wird zur Freisetzung der Säure aus dem Säurebildner vorzugsweise mit tiefem UV-Licht gearbeitet, d.h. im sogenannten DUV-Bereich (DUV = Deep UV). Das aromatenhaltige Basispolymer des Bottom-Resists absorbiert nämlich in diesem Wellenlängenbereich, so daß die Eindringtiefe des Lichts begrenzt ist. Ferner wird beim erfindungsgemäßen Verfahren vorteilhaft ein Säurebildner verwendet, der bei der Belichtung nicht ausbleicht und deshalb nur in der Oberflächenschicht photolysiert werden kann. Der Säurebildner darf auch keine im Sauerstoffplasma nicht-flüchtigen Oxide bilden. Bevorzugt werden deshalb Verbindungen, die unter UV-Licht Chlor abspalten und so als starke Säure HCl bilden, oder Crivellosalze, die beispielsweise Trifluormethansulfonsäure bilden.

Der Bottom-Resist soll während der strukturierenden Belichtung Reflexionen vom Substrat unterdrücken. Im tiefen UV, beispielsweise bei 248 nm, ist diese Forderung erfüllt, da das Basispolymer und der Säurebildner hier stark absorbieren. Wird jedoch im nahen UV, d.h. im sogenannten NUV-Bereich (NUV = Near UV), strukturierend belichtet, beispielsweise bei 365 oder 436 nm, so muß dem Bottom-Resist bzw. der Lackschicht ein für diesen Wellenlängenbereich lichtechter Farbstoff zugesetzt werden, um eine ausreichende Absorption zu erzielen.

Mit dem erfindungsgemäßen Verfahren kann auch eine bessere Planarisierung erreicht werden als bei einem rein thermisch gehärteten Resist. Bei der kombinierten photolytisch/thermischen Oberflächenhärtung ist nämlich der Volumenschwund geringer als bei der rein thermischen Härtung, die das gesamte Volumen erfaßt und bei höheren Temperaturen abläuft.

Der technische Aufwand ist beim erfindungsgemäßen Verfahren nicht viel größer als bei konventionellen Bottom-Resists mit thermischer Härtung. Es muß lediglich oberhalb der Ausheizstrecke ein starker UV-Strahler installiert werden, wie er beispielsweise von DUV-Härtungsanlagen bekannt ist. Die Belichtungszeiten liegen dann im Bereich weniger Sekunden, so daß bei der Belackung die üblichen Taktzeiten eingehalten werden können.

Anhand von Ausführungsbeispielen soll die Erfindung noch näher erläutert werden.

### Beispiel 1

### Bottom-Resist für eine 248 nm-Belichtung

Aus 22,7 MT eines käuflichen Phenolnovolaks (MT = Masseteile), 2,2 MT 2-(Trichlormethyl)-4(3H)-chinazolinon (als Säurebildner), 3,1 MT Hexamethylentetramin (als Vernetzer), 30 MT Benzylalkohol und 42 MT Cyclohexanon wird eine Lacklösung hergestellt. Diese Lösung wird auf einen 3 Zoll-Siliciumwafer aufgeschleudert, so daß eine Endschichtdicke von 1,8 µm erhalten wird. Nach Vortrocknung (90 °C, 60 s) auf einer Heizplatte und Flutbelichtung (DUV, 3000 mJ/cm) mit anschließendem Aufheizen auf ca. 150 °C (60 s) wird eine Schicht des Bottom-Resists mit vernetzter Oberfläche erhalten. Diese Oberfläche wird durch folgende Medien nicht mehr angelöst bzw. angequollen: Methoxypropylacetat (Lösungsmittel für den Top-Resist), NMD-W 2,38 % (käuflicher alkalischer Entwickler), Lösung eines oligomeren Diaminomethylsiloxans in einem 4:1-Gemisch von Isopropanol und Wasser (Aufweitungs- bzw. Silylierungsagens) und Isopropanol (Spülflüssigkeit).

Nach dem Belacken des Bottom-Resists mit einem siliciumhaltigen Top-Resist (siehe dazu beispielsweise EP-OS 0 395 917), der strukturierenden Belichtung des Top-Resists bei 248 nm mittels einer Maske in der Weise, daß bei der Entwicklung Resistlinien von 2 bis 0,5 µm entstehen, sowie der Aufweitungs- bzw. Silylierungsbehandlung (siehe dazu: "Proc. SPIE", Vol. 1262 (1990), Seiten 528 bis 537) und der Strukturübertragung im Sauerstoffplasma wird das Siliciumsubstrat im CF₄-Plasma bis zu einer Tiefe von 100 nm geätzt. Dabei zeigt sich, daß die Ätzstabilität des Bottom-Resists gleich groß ist wie die von kommerziellen Einlagen-Photoresists auf Novolakbasis. Nachfolgend wird der Bottom-Resist samt dem darauf befindlichen Top-Resist in einem Sprühentwickler (2 bar Tankdruck, 1000 Umdrehungen pro Minute) mit N-Methylpyrrolidon gestrippt. Rasterelektronenmikroskopische Untersuchungen zeigen, daß keine Reste des Bottom-Resists mehr vorhanden sind.

### Beispiel 2

### Bottom-Resist für eine 436 nm-Belichtung

Aus 20 MT eines käuflichen Phenolnovolaks (MT = Masseteile), 2 MT Triphenylsulfonium-trifluormethansulfonat (als Säurebildner), 6 MT Bis(hydroxymethyl)-p-kresol (als Vernetzer), 3 MT eines käuflichen gelben Farbstoffes und 67 MT Cyclohexanon wird eine Lacklösung hergestellt. Diese Lösung wird auf einen 3 Zoll-Siliciumwafer aufgeschleudert, so daß eine Endschichtdicke von 1,8 µm erhalten wird. Nach Vortrocknung (90 °C, 60 s) auf einer Heizplatte und Flutbelichtung (DUV, 3000 mJ/cm) mit anschließendem Aufheizen auf ca. 140 °C (60 s) wird eine Schicht des Bottom-Resists mit vernetzter Oberfläche erhalten. Diese Oberfläche wird durch folgende Medien nicht mehr angelöst bzw. angequollen: Methoxypropylacetat (Lösungsmittel für den Top-Resist), NMD-W 2,38 % (käuflicher alkalischer Entwickler), Lösung eines oligomeren Diaminomethylsiloxans in einem 4:1-Gemisch von Isopropanol und Wasser (Aufweitungs- bzw. Silylierungsagens) und Isopropanol (Spülflüssigkeit).

Nach dem Belacken des Bottom-Resists mit einem siliciumhaltigen Top-Resist (siehe dazu beispielsweise EP-0S 0 395 917), der strukturierenden Belichtung des Top-Resists bei 436 nm mittels einer Maske in der Weise, daß bei der Entwicklung Resistlinien von 2 bis 0,5 µm entstehen, sowie der Aufweitungs- bzw. Silylierungsbehandlung (siehe dazu: "Proc. SPIE", Vol. 1262 (1990), Seiten 528 bis 537) und der Strukturübertragung im Sauerstoffplasma wird das Siliciumsubstrat im CF₄-Plasma bis zu einer Tiefe von 100 nm geätzt. Dabei zeigt sich, daß die Ätzstabilität des Bottom-Resists gleich groß ist wie die von kommerziellen Einlagen-Photoresists auf Novolakbasis. Nachfolgend wird der Bottom-Resist samt dem darauf befindlichen Top-Resist in einem Sprühentwickler (2 bar Tankdruck, 1000 Umdrehungen pro Minute) mit N-Methylpyrrolidon gestrippt. Rasterelektronenmikroskopische Untersuchungen zeigen, daß keine Reste des Bottom-Resists mehr vorhanden sind.

## Patentansprüche

1. Verfahren zur Erzeugung eines Bottom-Resists für ein Zweilagen-O₂/RIE-system, **dadurch gekennzeichnet,** daß auf ein Substrat eine Lackschicht aus einem aromatenhaltigen Basispolymer, einem Vernetzer und einem Säurebildner aufgebracht wird, daß die Lackschicht - zur Freisetzung einer starken Säure aus dem Säurebildner im Oberflächenbereich der Schicht - flutbelichtet wird, und daß thermisch gehärtet wird.

2. Verfahren nach Anspruch 1, **dadurch gekennzeichnet,** daß ein bei Belichtung Chlorwasserstoff abspaltender Säurebildner verwendet wird.

3. Verfahren nach Anspruch 1, **dadurch gekennzeichnet,** daß als Säurebildner ein Crivellosalz verwendet wird.

4. Verfahren nach einem der Ansprüche 1 bis 3, **dadurch gekennzeichnet,** daß die Belichtung im DUV-Bereich erfolgt.

5. Verfahren nach einem oder mehreren der Ansprüche 1 bis 4, **dadurch gekennzeichnet,** daß als Basispolymer ein Novolak verwendet wird.

6. Verfahren nach einem oder mehreren der Ansprüche 1 bis 5, **dadurch gekennzeichnet,** daß als Vernetzer Hexamethylentetramin verwendet wird.

7. Verfahren nach einem oder mehreren der Ansprüche 1 bis 5, **dadurch gekennzeichnet,** daß als Vernetzer eine Novolak-Vorstufe verwendet wird.

8. Verfahren nach einem oder mehreren der Ansprüche 1 bis 7, **dadurch gekennzeichnet,** daß die Härtung bei einer Temperatur > 100 °C erfolgt.

## Claims

1. A method for producing a bottom resist for a two-layer O₂/RIE (reactive ion etch) system, characterised in that a varnish layer of an aromatics-containing base polymer, a cross-linking agent and an acid-forming agent is applied to a substrate, the varnish layer is flood-exposed to liberate a strong acid from the acid-forming agent in the surface region of the layer, and thermal curing is performed.

2. A method according to claim 1, characterised in that an acid-forming agent which, on exposure, splits off hydrogen chloride is used.

3. A method according to claim 1, characterised in that a Crivello salt is used as acid-forming agent.

4. A method according to one of claims 1 to 3, characterised in that the exposure takes place in the DUV (deep UV) region.

5. A method according to one or more of claims 1 to 4, characterised in that a Novolak is used as base polymer.

6. A method according to one or more of claims 1 to 5, characterised in that hexamethylene tetramine is used as cross-linking agent.

7. A method according to one or more of claim 1 to 5, characterised in that a Novolak precursor is used as cross-linking agent.

8. A method according to one or more of claims 1 to 7, characterised in that the curing takes place at a temperature >100°C.

## Revendications

1. Procédé pour préparer une couche de fond à partir d'une photoréserve pour un système bicouche O₂/RIE, caractérisé en ce qu'on applique sur un substrat, une couche de laque constituée par un polymère de base contenant des groupements aromatiques, par un agent de réticulation et par un acidificateur, en ce qu'on éclaire par le fond la couche de laque - pour libérer un acide fort de l'acidificateur dans le domaine superficiel de la couche - et en ce qu'on durcit par voie thermique.

2. Procédé selon la revendication 1, caractérisé en ce qu'on utilise, lors de l'éclairage, un acidificateur libérant de l'acide chlorhydrique.

3. Procédé selon la revendication 1, caractérisé en ce que, comme acidificateur, on utilise un sel de Crivello.

4. Procédé selon l'une des revendications 1 à 3, caractérisé en ce que l'éclairage a lieu dans la gamme du DUV.

5. Procédé selon l'une ou plusieurs des revendications 1 à 4, caractérisé en ce que, comme polymère de base, on utilise une Novolaque.

6. Procédé selon l'une ou plusieurs des revendications 1 à 5, caractérisé en ce que, comme agent de réticulation, on utilise l'hexaméthylènetétramine.

7. Procédé selon l'une ou plusieurs des revendications 1 à 5, caractérisé en ce que, comme agent de réticulation, on utilise un précurseur de Novolaque.

8. Procédé selon l'une ou plusieurs des revendications 1 à 7, caractérisé en ce que le durcissement a lieu à une température > 100°C.
